# EUROPEAN PATENT SPECIFICATION

(11) **EP 0 510 259 B1**
(45) Date of publication and mention of the grant of the patent: **26.07.1995**
(21) Application number: 91122029.1
(22) Date of filing: 20.12.1991
(51) Int. Cl.: C23C 14/24, C23C 14/26

(54) **Apparatus for vacuum deposition of a sublimable substance**
Vorrichtung zum Vakuum-Aufdampfen von einer sublimierbaren Substanz
Appareil pour dépôt sous vide d'une substance sublimable

(30) Priority: 03.04.1991 JP 70819/91
(43) Date of publication of application: 28.10.1992
(73) Proprietor: MITSUBISHI JUKOGYO KABUSHIKI KAISHA, Tokyo (JP)
(72) Inventor: Taguchi, Toshio, Mitsubishi Jukogyo K.K., Hiroshima-shi, Hiroshima-ken (JP); Sueda, Minoru, Mitsubishi Jukogyo K.K., Hiroshima-shi, Hiroshima-ken (JP); Hoshi, Younosuke, Mitsubishi Jukogyo K.K., Hiroshima-shi, Hiroshima-ken (JP); Kamikawa, Susumu, Mitsubishi Jukogyo K.K., Hiroshima-shi, Hiroshima-ken (JP)
(74) Representative: Henkel, Feiler, Hänzel & Partner

(56) References cited:
- GB-A- 766 119
- US-A- 3 446 936
- RCA TECNICAL NOTES, vol. 19, no. 723, 1 June 1967, P. GOLDSTEIN: "APPARATUS FOR EVAPORATING SUBLIMABLE MATERIALS"
- PATENT ABSTRACTS OF JAPAN, vol. 8, no. 130 (C-229)(1567), 16 June 1984; & JP-A-59 041 472
- Thin Film Committee, Japan Society for the Promotion of Science, "Thin Film Handbook", no. 131, 1983, Ohm Corp., p. 882
- Technical Bulletin of Mitsubishi Heavy Industries Ltd., vol. 27, no. 3, 1990-5, "Development of Air-to-Air Vacuum Metallizer for Food Packaging Film"

## Description

### BACKGROUND OF THE INVENTION

### Industrial Field of the Invention:

This invention relates to an apparatus for vacuum deposition of sublimable substance such as SiO₂ or SiO provided with a device for heating the sublimable substance.

### Description of the Prior Art:

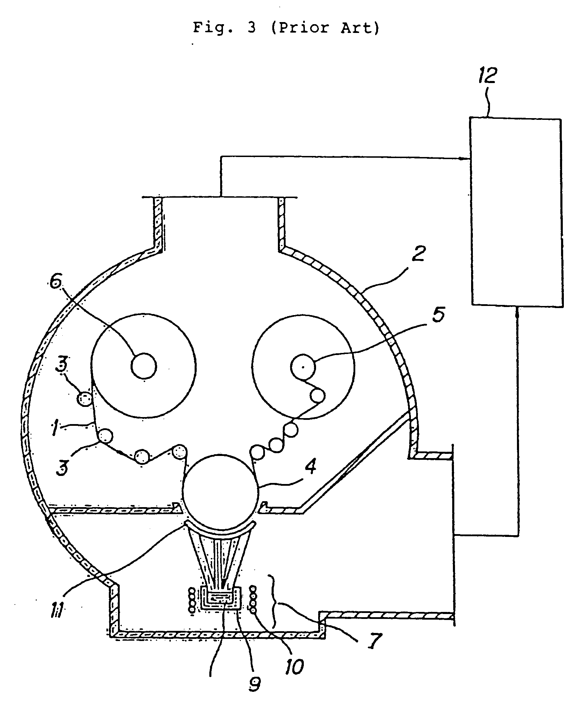

Heretofore, the formation of a thin film by the vacuum deposition of such a sublimable substance as SiO₂ or SiO on a base plate such as of paper or plastic film has been carried out with an apparatus constructed as illustrated in Fig. 3.

With reference to Fig. 3, a base plate 1 taken up in the form of a coil on a takeup reel 6 is set in place inside a vacuum deposition chamber 2 as connected to a takeup reel 5 via a deflector roll 3 and a cooling roll 4. After the interior of the vacuum deposition chamber 2 is evacuated by an exhaust pump unit 12 to a prescribed degree of vacuum, the base plate 1 is moved by the takeup reel 6, subjected to vacuum deposition effected with a vacuum deposition device 7 as cooled on the cooling roll 4 so as to decrease the temperature elevated in consequence of the application of heat during the vacuum deposition, and rewound on the takeup reel 5.

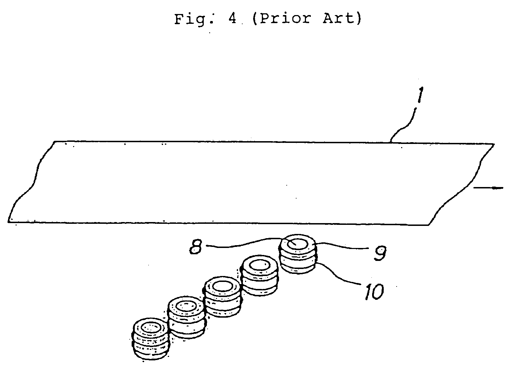

The vacuum deposition device 7, as illustrated in Fig. 4, is composed of a vacuum deposition material 8, a plurality of receptacles 9 arranged in the direction of width of the base plate 1 as spaced at stated intervals, and a heating device 10 for the receptacle 9. The vacuum deposition material 8 vaporized in the direction of the moving base plate 1.

When the vacuum deposition is effected with aluminum, for example, the receptacles 9 heretofore used in the art are made of graphite. When the vacuum deposition is performed with such a sublimable substance as SiO₂ or SiO, however, no ideal material has yet been found for the receptacles 9.

During this vacuum deposition, the vacuum deposition material 8 which has been vaporized is sent flying not only directly upwardly but also obliquely outwardly. To keep the vaporized vacuum deposition material from landing on the cooling roll 4 which is separated from the base plate 1, an edge mask 11 is so disposed as to form gaps one each from the opposite side parts of the base plate 1 and, at the same time, overlap its opposite side parts.

Since the conventional device has the plurality of receptacles 9 arranged in the direction of width of the moving base plate 1 as illustrated in Fig. 4, it allows distribution of the thickness of the vacuum deposited film in the direction of width of the base plate 1. When the vaporization is caused as attended by a reaction within the receptacles 9, such vacuum deposition materials as SiO₂ and Si are placed in the receptacles and caused to undergo the following reaction at an elevated temperature with evolution of SiO vapor.

SiO₂ + Si → 2SiO (vapor)

At this time, the distribution of the thickness of the vacuum deposited film occurs in the direction of width, depending on the positions of the receptacles 9 which are the positions for the generation of the reaction.

Incidentally, the speed of vaporization of the vacuum deposition material increases in accordance as the temperature of the vacuum deposition material rises. When the vacuum deposition material is a fusible substance, the conventional heating device suffices because the vacuum deposition material is fused within the receptacles and brought to a substantially uniform temperature therein. However, when the vacuum deposition material is a sublimable substance, since it is not fused but is caused to form voids therein, the voids impair conduction of heat through the material and lower apparent thermal conductivity thereof. The interior of the vacuum deposition material produces a temperature difference proportionate to the apparent thermal conductivity of the material. When the material is heated from the part other than the surface of vaporization as in the conventional device, therefore, the temperature of the receptacles is elevated to a point where problems occur in the heat resistance of the receptacles and the wear of the material of the receptacles owing to the reaction between the receptacles and the vacuum deposition material.

Documents showing the prior art discussed in combination with Figs. 3 and 4 are mentioned below:
Fig. 3: "Thin Film Handbook" Edited by No. 131 Thin Film Committee, Japan Society for the Promotion of Science, issued by Ohm Corp. (1983), P. 882.
Figs. 3 & 4: "Development of Air-to-Air Vacuum Metallizer for Food Packaging Film" Technical Bulletin of Mitsubishi Heavy Industries", Ltd. Vol. 27, No. 3 (1990-5).

British Patent 766,119 discloses an apparatus for vacuum deposition of a sublimated substance, in which above of the vacuum deposition material there is provided a baffle member in form of a plate or a bar by which a barrier to straight line movement of solid or liquid particles arising from the material in the receptacle is formed. Any solid or liquid particles striking the underside of the baffle plate or the baffle bar will be retained there or thrown back or evaporated with no unduly obstruction of the flow of the vapour.

RCA Technical Notes, Vol. 19, No. 723, published June 1, 1967 discloses again an apparatus for vacuum deposition of a sublimated substance comprising a receptacle made of molybdenum. Said receptacle or crucible has a thin seated top having a large central aperture. The material to be evaporated is placed within an inner chamber, which may be made of tantalum sheet, having perforations entirely around its lateral walls and top. Only the bottom of the chamber is unperforated. The perforations are very small so that they act as a filter and prevent large particles from being ejected from the chamber. As further protection against the escape of large particles, the chamber is nested within a can also made of tantalum sheet, having rows of perforations only around the lower portion of its lateral walls. The can is spaced a short distance from the chamber. The can is also spaced from the inner surface of the walls of the crucible. In order to space the can from the inner walls of the crucible, the top of the can is provided with a serrated flange. The openings between the serrations permit evaporated material to emerge and finaly be ejected through the central aperture of the crucible cover.

In view of the technical level described above and for the purpose of overcoming the drawbacks encountered by the prior art as described above, this invention aims to provide a vacuum deposition apparatus for a sublimable substance, which apparatus enables the sublimable substance to be uniformly vacuum deposited on a base plate and, at the same time, precludes the aforementioned problem of the wear of the receptacles due to the reaction between the sublimable substance and the material of the receptacles.

Thus the present invention provides an apparatus for vacuum deposition of a sublimated substance as defined by claim 1.

Preferably the apparatus according to claim 1 comprises an SiC film on an inner surface of said receptacle made from graphite.

Owing to the provision of the receptacle with the slit-like nozzle having a cross section smaller than the surface area of vaporization within the receptacle, the vapor of the vacuum deposition material is accelerated in the nozzle part and ejected at a flow rate uniform in the direction of width.

The upper surface of the receptacle for accommodating a vacuum deposition material is covered with the inductively heatable body made of graphite as opposed to the surface of vaporization of the vacuum deposition material inside the receptacle and this inductively heatable body is surrounded with the induction heating coil. Owing to this construction, the surface of vaporization is directly heated radially and compensated for the latent heat of vaporization. It is, therefore, the surface of vaporization that the highest temperature is registered throughout the entire volume of the vacuum deposition material.

Other objects and features of the present invention will become apparent as the disclosure is made in the following description of preferred embodiments of the invention, as illustrated in the accompanying drawings.

### BRIEF DESCRIPTION OF THE DRAWINGS

Fig. 1 illustrates a SiO vaporizing device contemplated in one embodiment of the present invention, (a) representing a cross section of the SiO vaporizing device, (b) a plan view of a induction heater shown in the diagram of (a), and (c) a side view of the induction heater shown in the diagram of (a).

Fig. 2 is a side elevation illustrating in cross section illustrating the overall construction of one example of a vacuum deposition apparatus using the vaporizing device of the embodiment described above.

Fig. 3 is a structural diagram of a vacuum deposition apparatus for a sublimable substance according the prior art.

Fig. 4 is an explanatory diagram representing the layout of receptacles for a sublimable substance in the device shown in Fig. 3.

### DETAILED DESCRIPTION OF THE PREFERRED EMBODIMENT

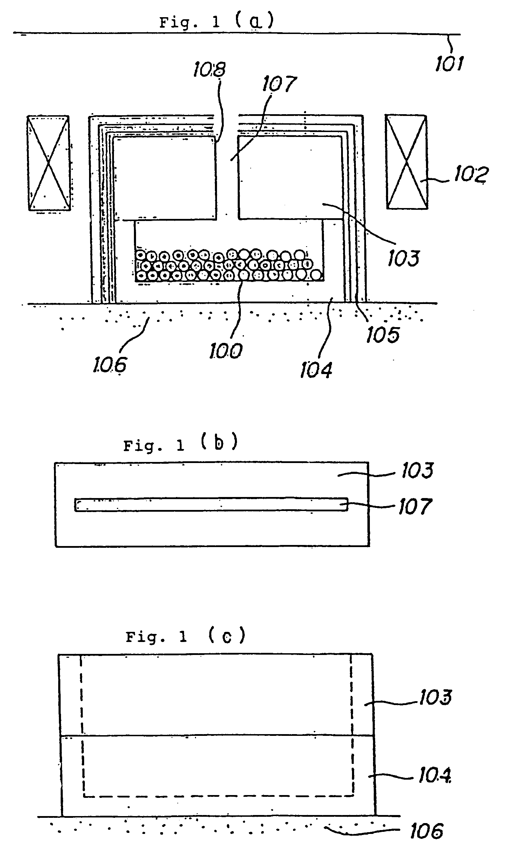

A vacuum deposition apparatus for a sublimable substance as one embodiment of this invention is illustrated in Fig. 1. The embodiment will be described specifically below with reference to this diagram.

Figs. 1 (a), (b), and (c) illustrate the construction of a SiO vaporizing device as the first embodiment of this invention; (a) representing a cross section of the device, (b) a plan view of the dielectric heater, and (c) a side view of the same dielectric heater.

In Fig. 1, 100 stands for a vacuum deposition material (pellets of mixture of SiO, Si, and SiO₂), 101 for a moving base plate, 102 for an induction heating coil, 103 for an inductively heatable body, 104 for a receptacle, 105 for a heatproofing plate, 106 for an insulating brick, 107 for a nozzle part, and 108 for a wall surface defining the nozzle part 107.

To be specific, the receptacle 104 is a member for accommodating and vaporizing the vacuum deposition material 100 and the inductively heatable body 103 has the slit-like nozzle part 107 formed in the wall surface thereof 108. It is through this nozzle part 107 that the vaporized vacuum deposition material is ejected. The receptacle 104 and the inductively heatable body 103 are both made of graphite.

The inductively heatable body 103 is disposed above the receptacle 104 in such a manner that the lower surface of the inductively heatable body 103 is opposed to the surface of vaporization of the vacuum deposition material 100.

The periphery of the inductively heatable body 103 and that of the receptacle 104 are covered with the heatproofing plate 105. Outside the receptacle 104, the induction heating coil 102 is disposed so as to surround the inductively heatable body 103. The receptacle 104 is superposed on the insulating brick 106 as illustrated in Fig. 1 (a) and the inductively heatable body 103 is superposed on the receptacle 104 as illustrated in Figs. 1 (b) and (c).

The inductively heatable body 103 is heated with an alternating magnetic field generated by the induction heating coil 102 consequently enabled to heat by radiation the surface of vaporization of the vacuum deposition material 100 through the medium of the space inside the receptacle 104. In consequence of the heating by radiation, the vacuum deposition material 100 emits the vapor of SiO from the surface of vaporization. The vapor of SiO has the speed of ejection thereof uniformized in distribution by the nozzle part 107 of the receptacle in the direction of width [the direction perpendicular to the surface of paper in Fig. 1 (a)], spouted out of the receptacle 104, and deposited on the moving base plate 101.

Now, the second embodiment of this invention will be described below with reference to Fig. 1.

The second embodiment comprises the receptacle 104 shown in Fig. 1 and the inductively heatable body 103, on the inner surfaces of which SiC film is formed.

As compared with the first embodiment which, at the outset of vacuum deposition, has the possibility of the SiO vapor generated within the receptacle 104 reacting with the receptacle 104 and the inductively heatable body 103 with evolution of CO gas and consequently degrading the degree of vacuum inside the receptacle, the second embodiment is free from this possibility.

The second embodiment, therefore, precludes the possible degradation of the degree of vacuum due to the generation of CO gas and ensures production of a vacuum deposition film of high quality.

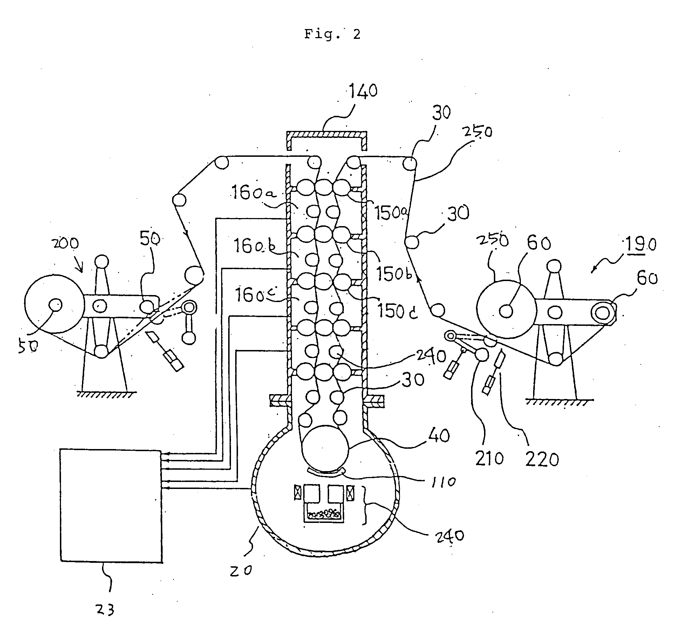

Fig. 2 is a side elevation illustrating in cross section the whole construction of one example of the vacuum deposition apparatus using the vaporing device embodying this invention as illustrated in Fig. 1.

With reference to Fig. 2, 250 stands for a moving base plate, 20 for a vacuum deposition chamber, 30 for a deflector roll for the moving base plate, 40 for a cooling roll disposed inside the vacuum deposition chamber 20, 50 for a takeup reel, 60 for an unwinding reel, 240 for a vaporizing device disposed inside the vacuum deposition chamber 20 and constructed as illustrated in Fig. 1, and 110 for an edge mask similar to what is shown in Fig. 3. A coiler 200 provided with one pair of takeup reels 50 and an uncoiler 190 provided with one pair of unwinding reels 60 are disposed on the opposite sides of the vacuum deposition chamber 20. The base plate 250 set on the unwinding reel 60 is passed through pressure chambers 160a, 160b, 160c, ... and around the cooling roll 40 inside the vacuum deposition chamber 20, sent in the reverse direction inside the pressure chambers, and taken up on the takeup reel 50. 150a, 150b, 150c, ... are three sets of seal rolls disposed between the pressure chambers or between the pressure chambers and the vacuum deposition chamber and adapted to pass the moving base plate 250 between the nipping surfaces thereof. A seal device 140 is composed of the pressure chamber 160a, 160b, 160c, ... and the seal rolls 150c, 150b, 150c, .... 210 stands for a pressing roll for the coil of the base plate 250 on the uncoiler 190, 220 for a cutter for the moving base plate 250 disposed near the uncoiler 190, and 23 for an exhaust pump unit for the vacuum deposition chamber 20 and the pressure chambers 160a, 160b, 160c ....

As illustrated in Fig. 2, the base plate 250 is set on one of the pair of reels 60 of the uncoiler 190 and paid out and advanced via the deflector 30 to the seal device 140.

The seal device 140 is provided with the pressure chambers 160a, 160b, 160c, ... which are partitioned by having a plurality of three-piece sets of seal rolls 150a, 150b, 150c, ... disposed as regularly spaced. By the exhaust pump unit 230 which is connected to the pressure chambers 160a, 160b, 160c, ..., a pressure gradient is formed from the atmosphere through the vacuum deposition chamber 20 to keep the vacuum deposition chamber 20 under a prescribed degree of vacuum.

The moving base plate 250 passes through the gap between two adjacent rolls in the total of three rolls of each of the three-piece sets of seal rolls 150a, 150b, 150c, ... and then through the pressure chamber 160a, 160b, 160c, ....

The moving base plate 250, while advancing on the cooling roll 40, has deposited thereon the vapor arising from the vaporizing device 240. Subsequently, it is advanced in the opposite direction through the gap formed between the remaining adjacent rolls in the total of three rolls of each of the three sets of seal rolls 150a, 150b, 150c, ... and discharged through the seal device 140.

The base plate 250 which has been discharged into the ambient air is rewound on one of the pair of reels 50 of the coiler 200 through the medium of the deflector roll 30.

The vacuum deposition apparatus for a sublimative substance according to the first and second aspects of this invention enables the sublimable substance to be vacuum deposited on the moving base plate uniformly in the direction of width of the base plate while allowing the sublimative substance to be improved in quality. Further, the temperature of the receptacle need not be elevated unduly and the possible wear of the receptacle can be precluded.

The possibility of the vapor of the vacuum deposition material being condensed and deposited on the inner wall surface of the nozzle is nil because the members forming the nozzle are made of a inductively heatable body and the temperature of the nozzle is kept above the temperature of the surface of vaporization.

## Claims

1. Apparatus for vacuum deposition of a sublimable substance, characterized in that an upper surface of a receptacle (104) for vacuum deposition material (100) is covered with an inductively heatable body (103) made of graphite, said inductively heatable body is provided in the central part thereof with a slit-like nozzle (107) having a cross section smaller than the surface area of vaporization of the vacuum deposition material held in said receptacle (104) during use of the apparatus, and said inductively heatable body is surrounded with an induction heating coil (102).

2. Apparatus for vacuum deposition of a sublimable substance according to claim 1, characterized by comprising a SiC film on an inner surface of said receptacle (104) made from graphite.

## Patentansprüche

1. Vorrichtung für das Vakuumaufdampfen einer sublimierbaren Substanz, dadurch gekennzeichnet, daß eine Oberseite eines Behälters (104) für Vakuumaufdampfmaterial (100) mit einem induktiv beheizbaren Körper (103) aus Graphit bedeckt ist, der induktiv beheizbare Körper in seinem Mittelbereich mit einer schlitzartigen Düse (107) eines Querschnitts, der kleiner ist als die Verdampfungsoberfläche des im Behälter (104) aufgenommenen Vakuumaufdampfmaterials im Gebrauch oder Betrieb der Vorrichtung, vorgesehen ist und der induktiv beheizbare Körper von einer Induktionsheizspule oder -wicklung (102) umgeben ist.

2. Vorrichtung für das Vakuumaufdampfen einer sublimierbaren Substanz nach Anspruch 1, gekennzeichnet durch einen SiC-Film auf einer Innenfläche des aus Graphit bestehenden Behälters (104).

## Revendications

1. Appareil pour dépôt sous vide d'une substance sublimable, caractérisé en ce qu'une surface supérieure d'un réceptacle (104) pour matière à déposer sous vide (100) est recouverte avec un corps chauffable par induction (103) fait en graphite, ledit corps chauffable par induction est muni dans sa partie centrale d'une buse en forme de fente (107) ayant une section transversale plus petite que l'aire de surface de vaporisation de la matière a déposer sous vide maintenue dans ledit réceptacle (104) durant l'utilisation de l'appareil, et ledit corps chauffable par induction est entouré d'une bobine de chauffage par induction (102).

2. Appareil pour dépôt sous vide d'une substance sublimable selon la revendication 1, caractérisé en ce qu'il comprend une pellicule de SiC sur une surface interne dudit réceptacle (104) fait en graphite.
